**Europäisches Patentamt**

**European Patent Office**

**Office européen des brevets**

(19)

(11) Veröffentlichungsnummer: **0 176 708 B1**

(12)

# EUROPÄISCHE PATENTSCHRIFT

(45) Veröffentlichungstag der Patentschrift:
**02.11.89**

(51) Int. Cl.⁴: **H02H 5/04, H03F 1/52**

(21) Anmeldenummer: **85109989.5**

(22) Anmeldetag: **08.08.85**

(54) Schaltungsanordnung zur Temperatursicherung mit Hysterese.

(30) Priorität: **10.08.84 DE 3429555**

(43) Veröffentlichungstag der Anmeldung:
**09.04.86 Patentblatt 86/15**

(45) Bekanntmachung des Hinweises auf die Patenterteilung:
**02.11.89 Patentblatt 89/44**

(84) Benannte Vertragsstaaten:
**AT DE FR GB IT NL**

(56) Entgegenhaltungen:
**EP-A- 0 103 455**
**EP-A- 0 106 378**
**DE-A- 2 710 762**
**FR-A- 2 377 106**
**US-A- 3 916 263**
**US-A- 4 345 218**

**TECHNICAL DIGEST, WESTERN ELECTRIC, Nr. 72, Oktober 1983, Seiten 15,16, New York, US; D.M. EMBREE u.a.: "Thermal shut-down circuit"**
**TIETZE/Schenk:**
**Halbleiter-Schaltungstechnik,6.Auflage 1983, Seiten 534-537**

(73) Patentinhaber: **Siemens Aktiengesellschaft, Wittelsbacherplatz 2, D-8000 München 2(DE)**

(72) Erfinder: **Lenz, Michael, Dipl.-Ing. (FH), Fischbachauerstrasse 3, D-8000 München 90(DE)**

**Beschreibung**

Die Erfindung betrifft eine Schaltungsanordnung nach dem Oberbegriff des Patentanspruches 1.

Elektronische Leistungsbauelemente, insbesondere integrierte Leistungsschaltkreise, benötigen eine Temperatursicherung als Schutz gegen unzulässig hohe Temperaturen bei ungenügender Kühlung, die zur Zerstörung des Bauelementes führen können. Als Temperatursensor dient üblicherweise ein mit einer temperaturunabhängigen Spannung in Flußrichtung vorgespannter Basis-Emitter- Übergang eines Transistors, der aufgrund des negativen Temperaturkoeffizienten seiner Schwellenspannung bzw. des positiven Temperaturkoeffizienten des Basisstromes ab einer bestimmten Temperatur aktiviert wird und die Verlustleistung im zu schützenden Baulement reduziert. Durch die thermische Kopplung des Temperatursensors und des Leistungsbauelements existiert eine Regelschleife, wobei die Regelung der Verlustleistung üblicherweise durch Ab- bzw. Einschalten der Versorgungsspannung für das Leistungsbauelement erfolgt.

Bei dieser Analogregelung, der sogenannten Pulsbreitenregelung, kommt es oft zu niederfrequenten Kippschwingungen mit überlagerten hochfrequenten Schwingungen. Die niederfrequenten Schwingungen entstehen, weil der Regelkreis aufgrund der thermischen Rückkopplung auf den Temperatursensor sehr langsam arbeitet, und die hochfrequenten Schwingungen entstehen bei den Schaltvorgängen des Reglers, d.h. des als Temperatursensors verwendeten Transistors.

Speziell bei integrierten Audioverstärker-Schaltungen stören die niederfrequenten Kippschwingungen, weil sie im Hörbereich liegen. Der auf halbem Versorgungsspannungspotential liegende Ausgang der bei integrierten Leistungsverstärkern bevorzugt benutzten B-Endstufe ist über einen Elektrolytkondensator hoher Kapazität mit dem Lautsprecher verbunden, an dem bei den Schaltvorgängen des Reglers hohe Stromamplituden auftreten, die unter Umständen den Lautsprecher beschädigen können. Die hochfrequenten Schwingungen führen allgemein zu Querströmen in den B-Endstufen, deren Ausgangstransistoren dabei soviel Leistung aufnehmen können, daß sich sogenannte «hot spots» (heiße Flecken) bilden, die zu einem lokalen Durchbruch zweiter Art führen und den oder die Transistoren zerstören.

Aus der EP-A 0 106 378 ist eine Schaltungsanordnung bekannt, welche aus einer eine temperaturabhängige Referenzspannung liefernden Bandgap-Schaltung, einer die Referenzspannung verstärkenden Verstärkerschaltung und einer Sensorschaltung, die die von der Verstärkerschaltung verstärkte Referenzspannung mit einer temperaturabhängigen Spannung vergleicht und bei Erfüllung eines Vergleichskriteriums Mittel zum Steuern von mit der Sensorschaltung thermisch gekoppelten temperaturbestimmenden Schaltungsteilen aktiviert, wobei eine Rückwirkung der Sensorschaltung auf deren Eingang besteht. Dabei wird mit der Rückwirkung der Sensorschaltung eine thermische Hysterese erzeugt, die ein unerwünschtes Schwingen der Schaltungszustände im Schutzfall vermeidet.

In Tietze/Schenk, 6. Auflage 1983, Seiten 534–537 sind darüber hinaus Bandgap-Schaltungen mit Gegenkopplungsnetzwerk beschrieben. Auch ist eine Rückkopplung der Sensorschaltung auf ein sensorschaltungsinternes Gegenkopplungsnetzwerk beispielsweise aus der DE-A 2 710 762 bekannt, um eine Hysteresekennlinie zu erzielen.

Der Erfindung liegt die Aufgabe zugrunde, eine alternative Schaltungsanordnung mit Hysteresekennlinie anzugeben.

Diese Aufgabe wird bei einer Schaltungsanordnung der eingangs erwähnten Art erfindungsgemäß durch die Merkmale des kennzeichnenden Teils des Patentanspruches 1 gelöst.

Die erfindungsgemäße Schaltungsanordnung vermeidet wie bekannt das Auftreten parasitärer Schwingungen durch das Ein- und Abschalten der Leistungsbauelemente, insbesondere integrierter Leistungsschaltkreise, nach einer Hysteresekennlinie. Die Besonderheit besteht nun darin, die Rückkopplung der Sensorschaltung auf den vorgelagerten Referenz-Spannungs-Verstärker und dort speziell auf dessen Gegenkopplungsnetzwerk vorzusehen.

Ausgestaltungen des Erfindungsgedankens sind in abhängigen Ansprüchen gekennzeichnet.

Die Erfindung wird im folgenden anhand dreier in den Figuren der Zeichnung dargestellter Ausführungsbeispiele näher erläutert.

Es zeigt:

Fig. 1 ein schematisches Schaltbild einer Schaltung zur Temperatursicherung mit Hysterese,

Fig. 2 ein Schaltbild einer erfindungsgemäßen Schaltungsanordnung und

Fig. 3 ein weiteres Schaltbild einer erfindungsgemäßen Schaltungsanordnung.

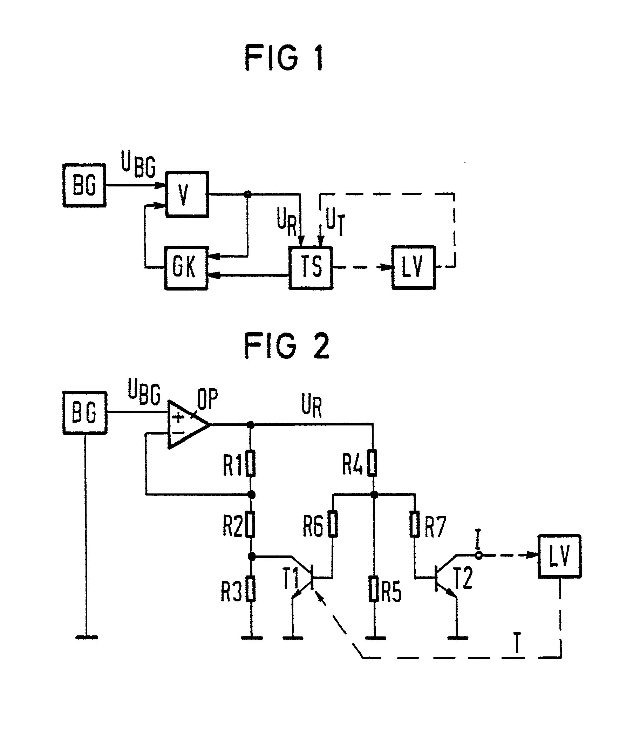

Gemäß Fig. 1 liefert eine an sich bekannte Bandgap-Schaltung BG eine in erster Näherung temperaturunabhängige Referenzspannung $U_{BG}$. Eine von ihrem Ausgang auf den Eingang durch ein Gegenkopplungsnetzwerk GK rückgekoppelte Verstärkerschaltung V verstärkt die Referenzspannung $U_{BG}$ auf die Spannung $U_R$. Eine mit dem zu schützenden Leistungsbauelement, insbesondere einem Leistungsverstärker LV thermisch gekoppelte Sensorschaltung TS vergleicht die verstärkte Referenzspannung $U_R$ mit einer temperaturabhängigen Spannung $U_T$. Bei Erfüllung eines Vergleichskriteriums wirkt die Sensorschaltung TS derart auf das Gegenkopplungsnetzwerk GK, das sich der Verstärkungsfaktor der Verstärkerschaltung V im Sinne einer Mitkopplung für die verstärkte Referenzspannung $U_R$ ändert. Gleichzeitig schaltet die Sensorschaltung TS den Leistungsverstärker LV beispielsweise über dessen Abschalteingang (Inhibit) ab bzw. ein.

Durch die Mitkopplung und den geänderten Verstärkungsfaktor für die verstärkte Referenzspannung $U_R$ ist das Vergleichskriterium sicher erfüllt und der Schaltzustand der Sensorschaltung TS für den Leistungsverstärker LV bleibt zuverlässig erhalten, bis sich die vom Leistungsverstärker LV auf die Sensorschaltung TS rückgekoppelte temperaturabhängige Spannung $U_T$ im Sinne einer Gegenkopplung derart geändert hat, daß wiederum das Vergleichskriterium erfüllt ist. Da sich allerdings die Vorzeichen des Temperaturkoeffizienten der temperaturabhängigen Spannung $U_T$ und der Differenz dieser Spannung $U_T$ und der verstärkten Referenzspannung $U_R$ gegenüber dem Ausgangszustand umgekehrt haben, erfolgt in diesem Fall die Annäherung an das Vergleichskriterium ebenfalls mit umgekehrtem Vorzeichen. Die Sensorschaltung TS wird nun wiederum im Sinne einer Mitkopplung für die verstärkte Referenzspannung $U_R$ derart auf das Gegenkopplungsnetzwerk GK ein, daß sich wieder der ursprüngliche Verstärkungsfaktor für die gegengekoppelte Verstärkerschaltung V einstellt. Das Vergleichskriterium ist damit ebenfalls sicher erfüllt und gleichzeitig schaltet die Sensorschaltung TS den Leistungsverstärker LV in den ursprünglichen Betriebszustand zurück.

Je nach Betriebszustand der Sensorschaltung besitzt die gegengekoppelte Verstärkerschaltung V zwei Verstärkungsfaktoren für die Referenzspannung $U_{BG}$ und demzufolge die verstärkte Referenzspannung $U_R$ zwei unterschiedliche Werte. Bei gleichbleibendem Vergleichskriterium entscheidet daher das Vorzeichen des Temperaturkoeffizienten der temperaturabhängigen Spannung $U_T$ bzw. die Richtung der Annäherung dieser Spannung $U_T$ an das Vergleichskriterium über eine Änderung der Ausgangsgrößen der sensorschaltung TS. Somit ergibt sich eine temperaturabhängige Hysteresekennlinie, deren Umschaltpunkte durch die Werte der verstärkten Referenzspannung $U_R$ einzustellen sind. Aufgrund der Mitkoppelschleife, die von der Sensorschaltung TS über das Gegenkopplungsnetzwerk GK und die Verstärkerschaltung V geschlossen ist, erfolgt die Änderung insbesondere der auf den Leistungsverstärker LV wirkenden Ausgangsgröße der Sensorschaltung TS so schnell, daß keine parasitären Schwingungen auftreten.

Fig. 2 zeigt eine detaillierte Ausführungsform der schematischen Schaltung nach Fig. 1, wobei gleiche Elemente wie in Fig. 1 mit gleichen Bezugszeichen versehen sind.

Bandgap-Schaltungen sind bekannt und beispielsweise in dem Buch "Halbleiter-Schaltungstechnik" von U.Tietze und Ch. Schenk, 5. überarbeitete Auflage, Springer-Verlag, Berlin, Heidelberg, New York 1980, S. 387 ff. be schrieben. Eine derartige Bandgap-Schaltung BG liefert eine in erster Näherung temperaturunabhängige Spannung $U_{BG}$, die auf den nicht invertierenden Eingang eines in der Verstärkerschaltung enthaltenen Operationsverstärkers OP geschaltet ist.

Die verstärkte Referenzspannung $U_R$ am Ausgang des Operationsverstärkers OP wird über den Widerstand R1 auf den invertierenden Eingang des Operationsverstärkers OP rückgekoppelt. Der Widerstand R1 gehört zum Gegenkopplungsnetzwerk, das außerdem die zu R1 in Serie liegenden Widerstände R2 und R3 enthält und als Spannungsteiler für die auf das Bezugspotential bezogene verstärkte Referenzspannung $U_R$ dient. Dabei ist die Referenzspannung $U_{BG}$ der Bandgap-Schaltung ebenfalls auf das Bezugspotential bezogen.

Parallel zum Gegenkopplungsnetzwerk R1 bis R2 liegt ein weiterer ohmscher Spannungsteiler, bestehend aus den Widerständen R4 und R5, die zwischen die Ausgangsspannung $U_R$ des Operationsverstärkers OP und das Bezugspotential geschaltet sind. Parallel zu dem mit seinem einen Anschluß auf dem Bezugspotential liegenden Widerstand R5 sind jeweils ein Widerstand R6 bzw. R7 und eine je in Serie liegende Basis- Emitter- Strecke eines npn-Transistors T1 bzw. T2 gegen das Bezugspotential geschaltet. Der Kollektor des Transistors T1 ist mit dem Verbindungspunkt der Widerstände R2 und R3 des Gegenkopplungsnetzwerks GK verbunden und stellt die Rückkopplung der aus den Widerständen R4 bis R7 und den Transistoren T1 und T2 bestehenden Sensorschaltung auf das Gegenkopplungsnetzwerk dar. Der Kollektor des Transistors T2 bleibt offen und läßt sich mit seinem Anschluß I beispielsweise auf den Inhibit-Eingang eines Leistungsverstärkers LV schalten, wie in Fig. 2 gestrichelt skizziert ist.

Das zu schützende Leistungsbauelement, beispielsweise der Leistungsverstärker LV, ist mit dem Transistor T1 thermisch gekoppelt und bestimmt durch seinen Temperaturgang die temperaturabhängige Schwellenspannung des Basis-Emitter-Übergangs des Transistors T1, die in Fig. 1 mit $U_T$ bezeichnet ist.

Der Ausgangskreis des Transistors T1 liegt parallel zum Widerstand R3 und bestimmt mit den Widerständen R1 und R2 des Gegenkopplungsnetzwerks den Verstärkungsfaktor des Operationsverstärkers OP für die verstärkte Referenzspannung $U_R$. Mit Hilfe des Spannungsteilers R4 und R5 werden die Basen der Transistoren T1 und T2 vorgespannt, wobei die Widerstände R6 und R7 zur Symmetrierung dienen.

Bei nicht angesprochener Temperatursicherung ist der Leistungsverstärker LV eingeschaltet und die Transistoren T1 und T2 sperren. Mit steigender Verlustleistung des Leistungsverstärkers LV erhöht sich die Temperatur des pn-Übergangs des mit dem Leistungsverstärker LV thermisch gekoppelten Transistors T1. Aufgrund des negativen Temperaturkoeffizienten der Schwellenspannung des pn-Übergangs des Transistors T1 erniedrigt sich die Schwellenspannung $U_T$ bei steigender Temperatur T. Wählt man die durch die Widerstände R4 bis R6 eingestellte Basisvorspannung für den Transistor T1 so groß, daß die Schwellenspannung $U_T$ diese Basisvorspannung gerade bei der maximalen für das zu schützende Leistungsbauelement zulässigen Temperatur erreicht, dann schaltet der Transistor T1 durch. Die über dem Widerstand R3 des Gegenkopplungsnetzwerkes abfallende Spannung reduziert sich durch den dann parallel geschalteten Ausgangskreis des Transistors T1.

Gleichzeitig verringert sich die am Verbindungspunkt der beiden Widerstände R1 und R2 abgegriffene, auf den invertierenden Eingang des Operationsverstärkers OP rückgekoppelte Spannung und der Verstärkungsfaktor des Operationsverstärkers OP nimmt zu. Damit steigt die Ausgangsspannung $U_R$ und über den Spannungsteiler R4 bis R6 die Basis-Emitter-Spannung des Transistors T1. Diese Mitkopplung erhöht die verstärkte Referenzspannung $U_R$ solange bis der Transistor T1 in die Sättigung gelangt.

Mit dem Anwachsen der verstärkten Referenzspannung $U_R$ erhöht sich ebenfalls die Basisspannung des Transistors T2, so daß der Transistor T2 durchschaltet und über seinen Ausgang I den Leistungsverstärker LV, beispielsweise über dessen Inhabit-Eingang, abschaltet. Durch die Dimmensionierung der Basis-Vorwiderstände R6 bzw. R7 ist dafür Sorge zu tragen, daß der Transistor T2, der mit dem Leistungsverstärker LV nicht thermisch gekoppelt sein muß, nicht vor dem Transistor T1 schaltet. Der Anstieg der verstärkten Referenzspannung $U_R$ erfolgt durch die Mitkopplung so schnell, daß die beiden Transistoren T1 und T2 symmetrisch angesteuert werden können, ohne daß parasitäre Schwingungen beim Abschalten des Leistungsverstärkers LV auftreten. Speziell ist es jedoch vorteilhaft, daß der Transistor T2 bei nicht angesprochener Temperatursicherung eine niedrigere Basisvorspannung als der Transistor T1 besitzt und dann geringfügig später als dieser durchschaltet.

Erniedrigt sich nun bei abgeschaltetem Leistungsverstärker LV die Temperatur, dann steigt die damit gekoppelte Schwellenspannung $U_T$ des Transistors T1. Sobald die zunehmende Schwellenspannung $U_T$ die verstärkte Referenzspannung $U_R$ erreicht, beginnt der Transistor T1 zu sperren und über das Gegenkopplungsnetzwerk R1 bis R3 und den dann stärker gegengekoppelten Operationsverstärker OP verringert sich die verstärkte Referenzspannung $U_R$. Durch die neuerliche Mitkopplung erreicht die verstärkte Referenzspannung $U_R$ sehr schnell den niedrigeren, bei nicht angesprochener Temperatursicherung vorhandenen Spannungswert und die Transistoren T1 und T2 sperren zuverlässig. Aufgrund des durch die Mitkopplung erreichten schnellen Abschaltens der Tranistoren T1 bzw. T2 treten auch beim Wiedereinschalten des Leistungsverstärkers LV keine parasitären Schwingungen auf.

Die verstärkte Referenzspannung $U_R$ selbst ist aufgrund der parasitären Eigenschaften des Operationsverstärkers OP temperaturabhängig. Die Offsetgrößen lassen sich zwar für einen Betriebspunkt kompensieren, nicht jedoch ihre Temperaturdrift. Allerdings spielen diese Größen in der Praxis keine Rolle, da sie um mindestens eine Größenordnung niedriger als der Temperaturkoeffizient des Sensortransistors T1 liegen und die Verstärkung des Operationsverstärkers OP niedrig gehalten ist. Die Hysteresekennwerte der verstärkten Referenzspannung $U_R$ lassen sich über das Gegenkopplungsnetzwerk R1 bis R3 und den Spannungsabfall über dem Widerstand R3 bei durchgeschaltetem bzw. gesperrtem Transistor T1 einstellen. Bei der Dimmensionierung der Schaltung ist es nicht unbedingt erforderlich, daß der durchgeschaltete Transistor T1 in die Sättigung gelangen muß.

In speziellen Fällen ist die Kombination des als Temperaturfühler dienenden pn-Übergangs mit dem Schalttransistor T1 für das Gegenkopplungsnetzwerk R1 bis R3 nicht erforderlich. Statt dessen kann man zusätzlich zu den Transistoren T1 und T2 eine Diode vorsehen, die beispielsweise in Serie zum Widerstand R4 liegt und mit ihrer Kathode am Verbindungspunkt der Widerstände R5 bis R7 angeschossen ist. Dies ist insbesondere bei symmetrischer Ansteuerung der Transistoren T1 und T2 sinnvoll. Bei möglicherweise anderen Kriterien für das Ansprechen der Temperatursicherung kann die Diode aber auch in Serie zu den Widerständen R6 oder R7 und deren gemeinsamem Verbindungspunkt liegen. Bei einem Anschluß einer Diode zwischen dem gemeinsamen Verbindungspunkt der Widerstände R4 bis R7 und dem Widerstand R5 ändert sich das Vorzeichen für die Ansteuerung der Transistoren T1 und T2, so daß in diesem Fall ein zusätzlicher Inverter oder Transisotren anderen Typs vorzusehen sind, um eine Mitkopplung zu erreichen. Statt der beschriebenen Anschlußmöglichkeiten für eine Diode läßt sich auch eine Zenerdiode einsetzen, wobei allerdings die andere Polungsrichtung und die Zenerspannung zu beachten sind.

Bei Zenerspannungen unter 5,7 Volt ist der Temperaturkoeffizient wie bei einer Diode negativ, darüber aufgrund des dann wirksamen Avalanche-Effekts positiv.

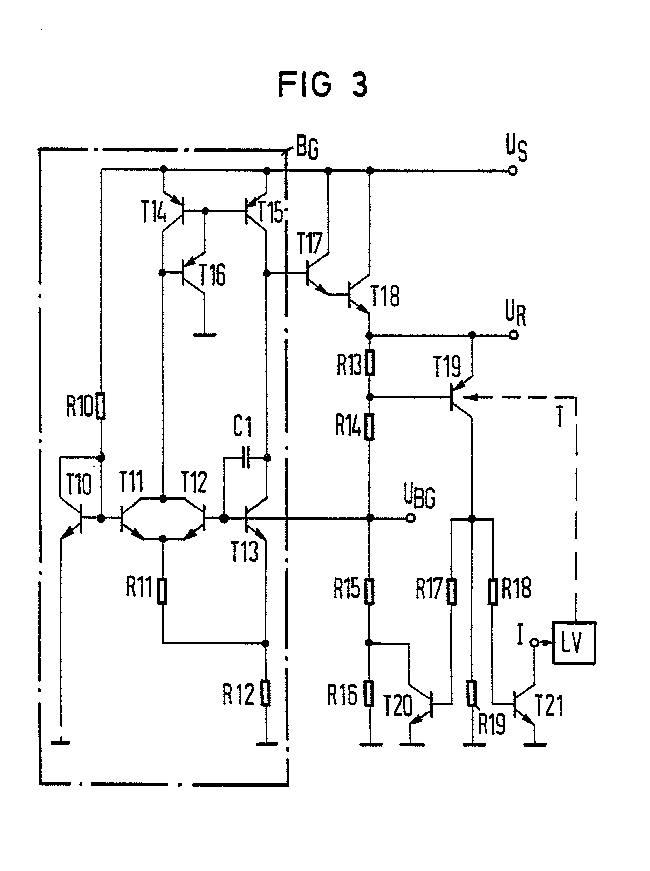

In Fig. 3 ist ein weiteres Ausführungsbeispiel einer erfindungsgemäßen Schaltungsanordnung mit detailliert angegebener Bandgap-Referenz- und Verstärkerschaltung dargestellt. Die im gestrichelt umrahmten Schaltungsteil ausgeführte Bandgap-Schaltung BG enthält die Transistoren T10 bis T16, die Widerstände R10 bis R12 und die Kapazität C1. Die Transistoren T10 bis T13 sind vom npn-Typ und die Transistoren T14 bis T16 vom pnp-Typ. Der Basis des als Diode geschalteten Transistors T10, dessen Emitter mit dem Bezugspotential, beispielsweise der Masse, verbunden ist, wird über den zwischen diesem Anschluß und der Versorgungsspannung $U_S$ liegenden Widerstand R10 ein Strom eingeprägt. Die Basis von T10 ist außer mit dem Kollektor und, dem Widerstand von R10 auch mit der Basis des Transistors T11 verbunden, der mit dem Transistor T12 einen Differenzverstärker bildet. Als Emitterwiderstand dieser Differenzverstärker stufe dienen die beiden in Serie gegen das Bezugspotential geschalteten Widerstände R11 und R12.

Die Basis des Transistors T12 ist mit der Basis des Transistors T13 verbunden, dessen Emitter am Verbindungspunkt der beiden Widerstände R11 und R12 liegt. Die Kapazität C1 überbrückt die Basis-Kollektor-Strecke des Transistors T13. Die Kollektoren der Differenzverstärkertransistoren T11 und T12 sind miteinander und mit dem Kollektor des Transistors T14 verbunden, der zusammen mit dem Transistor T15 einen Stromspiegel bildet, wobei der Kollektor des Transistors T15 auf den Kollektor des Transistors T13 geführt ist. Die Emitter der beiden Transistoren T14 und T15 werden von der Spannung $U_S$ versorgt, und parallel zur Basis-Kollektor-Strecke des Transistors T14 liegt die Emitter-Basis-Strecke des Transistors T16, dessen Kollektor gegen das Bezugspotential geschaltet ist.

Den Ausgang der Bandgap-Schaltung BG bildet der Kollektor des Transistors T13,der zum Eingang einer Darlington- Verstärkerstufe führt, die aus den Transistoren T17 und T18 besteht. Beide Transistoren vom npn-Typ liegen mit ihren Kollektoren an der Versorgungsspannung $U_S$ und der Emitter des Transistors T17 führt auf die Basis des Transistors T18. Den Ausgang der Darlington-Stufe bildet der Emitter des Transistors T18, an dem die verstärkte Referenzspannung $U_R$ abzugreifen ist. Das Gegenkopplungsnetzwerk dieser Schaltung nach Fig. 3 bilden die in Serie geschalteten Widerstände R13 bis R16, die zwischen dem Emitter des Transistors T18 und dem Bezugspotential liegen. Der Verbindungspunkt der Widerstände R14 und R15 ist mit den gemeinsamen Basen der Transistoren T12 und T13 der Bandgap-Schaltung BG verbunden und besitzt die Bandgap-Spannung $U_{BG}$.

Der Verbindungspunkt des Emitters des Transistors T18 und des Widerstandes R13 ist mit der Klemme $U_R$ und dem Emitter des als Temperatursensor dienenden Transistors T19 verbunden, dessen Basis am Verbindungspunkt der beiden Widerstände R13 und R14 liegt. Der Kollektor von T19 führt zum Verbindungspunkt der Widerstände R17 bis R19. R17 und R18 sind jeweils die Basisvorwiderstände der Transistoren T20 und T21, deren Emitter auf Bezugspotential liegen.

Parallel zu den Basis-Emitter-Strecken dieser Transistoren und ihren Basisvorwiderständen liegt der Wiederstand R19. Der Kollektor von T20 ist mit dem Verbindungspunkt der Widerstände R15 und R16 verbunden, während der Kollektor des Transistors T21 zur Klemme I führt und in der Regel offenbleibt, beispielsweise um den Abschalteingang (Inhibit) eines Leistungsverstärkers LV anzusteuern. Der Leistungsverstärker LV ist mit dem Transistor T19 thermisch gekoppelt.

Die Transistoren T10 und T11 dienen in Verbindung mit dem Widerstand R10 als Anlaufschaltung. Beim Einschalten der Versorgungsspannung $U_S$ fließt ein Strom durch den Widerstand R10, der sich auf die Basis-Emitter- Strecken der Transistoren T10 und T11 aufteilt. Mit T11 leitet auch der Stromspiegeltransistor T14, dessen Strom in T15 gespiegelt wird und den Darlington-Verstärker aus T17 und T18 ansteuert, der eine hohe Stromverstärkung besitzt. Über den Spannungsabfall an den Widerständen R13 bis R16 und den auf die Basen der Transistoren T12 bzw. T13 rückgekoppelten Verbindungpunkt der Widerstände R14 und R15 steigt das Potential an diesem mit der Klemme $U_{BG}$ verbundenen Punkt. Sobald die Schwellenspannungen der Transistoren T12 und T13 überschritten sind, übernimmt T12 den Strom von T11 und der Transistor T13 teilweise den Strom von T15. Durch die Gegenkopplung des Kollektorstromes von T13 über die Darlington-Verstärkerstufe T17 und T18 und das Gegenkopplungsnetzwerk auf die Basis von T13 stellt sich eine konstante Basisspannung an T13 ein.

Die in den Kollektorkreisen der Transistoren T12 und T13 fließenden Ströme sind einander in hohem Maße gleich, da der Kollektorstrom durch den Transistor T14 sehr exakt im Transistor T15 gespiegelt wird. Dazu dient der Transistor T16, dessen Basis-Emitterstrecke zwischen die Kollektorbasisstrecke des Transistors T14 geschaltet ist und dessen Basisstrom etwa um den Stromverstärkungsfaktor des Transistors T16 niedriger liegt als der Basisstrom der Transistoren T14 und T15. Vorteilhaft wählt man deswegen für den Transistor T16 einen vertikalen pnp-Transistor, dessen Stromverstärkungsfaktor etwa doppelt so groß wie bei einem lateralen pnp-Transistor ist.

Die Emitterfläche des Transistors T12 beträgt ein Vielfaches der Emitterfläche des Transistors T13, beispielsweise 7, so daß bei gleichen Kollektorströmen die Schwellenspannung beim Transistor T12 niedriger als beim Transistor T13 liegt. Dabei ist der Spannungsabfall über der Basis-Emitter-Strecke des Transistors T13 gleich groß wie der Spannungsabfall über der Basis- Emitter-Strecke des Transistors T12 und des in Serie liegenden Widerstandes R11. Die Differenz der beiden Basis-Emitter-Spannungen der Transistoren T12 und T13 erscheint am Widerstand R12 verstärkt. Der Temperaturkoeffizient der Spannung $U_{BG}$ wird dann in erster Näherung gleich Null, wenn man das Verhältnis der Emitterflächen der Transistoren T12 und T13 und die Widerstände R11 und R12 so wählt, daß sich die Bandgap-Spannung, in diesem Fall beispielsweise 1,16 Volt ergibt. Der Verstärker und der Rückkoppelkreis halten dieses Potential konstant.

Die verstärkte Referenzspannung $U_R$ beträgt beispielsweise 3,8 Volt. Aufgrund der für diese niedrige Verstärkung erforderlichen starken Gegenkopplung muß die Bandbreite dieser Schaltung begrenzt werden, um eventuelle Schwingungsneigungen zu unterdrücken. Dafür sorgt die Kapazität C1, die den Kollektor des Transistors T13 auf seine Basis rückkoppelt.

Der durch die als ohmscher Spannungsteiler geschalteten Widerstände R13 bis R16 des Gegenkopplungsnetzwerks fließende Strom erzeugt am Widerstand R13 einen anteilmäßigen Spannungsabfall, der die Emitter-Basis-Strecke des pnp-Transistors T19 in Flußrichtung vorspannt. Die Emitter-Basis-Schwellenspannung des Transistors T19 sinkt bei zunehmender Temperatur des zu schützenden, mit dem Transistor T19 thermisch gekoppelten Leistungsbauelements, beispielsweise des Leistungsverstärkers LV.

Sobald die Schwellenspannung unter die verstärkte Referenzspannung $U_R$ sinkt, leitet der Ausgangskreis dieses Transistors T19 und der dem Kollektor nachgeschaltete Eingangskreis des Transistors T20 schaltet diesen Transistor durch. Da der Ausgangskreis des Transistors T20 parallel zum Widerstand R16 liegt, sinkt die über diesem Widerstand abfallende Spannung. Andererseits hält der Verstärker die Bandgap-Referenzspannung $U_{BG}$ am Verbindungspunkt der beiden Widerstände R14 und R15 konstant und der Strom durch die Widerstände R13 bis R15 und die Parallelschaltung aus R16 und den Ausgangskreis des Transistors T20 steigt. Damit steigt der Spannungsabfall über dem Widerstand R13 und über der Emitter-Basis-Strecke des Transistors T19.

Der Ausgangsstrom des Transistors T19 wirkt so lange auf den Transistor T20 im Sinne einer Mitkopplung für die Emitter-Basis-Strecke des Transistors T19, bis T20 in die Sättigung gelangt. Für das Schaltverhalten des Transistors T21, dessen Ausgang auf den Abschalteingang beispielsweise des Leistungsverstärkers LV wirkt, gelten die zu Fig. 2 gemachten Erläuterungen analog. Dabei darf T21 gleichzeitig mit T20 schalten, vorteilhafterweise jedoch nicht vorher.

Durch das schnelle Abschalten der Sensorschaltung aufgrund der Mitkopplung spielt es keine wesentliche Rolle, ob der Transistor T19 in die Sättigung gelangt. Ebenso läßt sich T19 durch eine Diode oder Zenerdiode entsprechend den Ausführungen zu Fig. 2 ersetzen. Allerdings läßt sich nach Fig. 3 die Diodenvorspannung mit Hilfe des Transistors T19 und des Widerstandes R13 einfacher einstellen, ohne daß die Rückwirkung auf das Gegenkopplungsnetzwerk ins Gewicht fällt.

Nimmt die Temperatur des zu schützenden Leistungsbauelementes, beispielsweise des Leistungsverstärkers LV, ab und steigt die Schwellenspannung des Transistors T19, so wiederholt sich der Abschaltvorgang in umgekehrter Richtung. Zunächst kommt der Transistor T20 aus der Sättigung, dadurch erhöht sich der Spannungsabfall am Widerstand R16, der Strom durch das Gegenkopplungsnetzwerk nimmt ab und die Emitter-Basis-Spannung für den Transistor T19 nimmt ebenfalls ab. Durch die erneute Mitkopplung schalten die Transistoren T20 und T21 sehr schnell ab, so daß der Leistungsverstärker LV wieder zuschalten kann, ohne daß parasitäre Schwingungen auftreten. Der widerstand R19 dient als Ausräumwiderstand, der nach Abschalten des Transistors T19 die Basen der Transistoren T20 und T21 statisch auf Bezugspotential legt. Bei einer typischen Änderung der Basis-Emitter- Spannung des Transistors T19 von 50mV und einem Temperaturkoeffizienten des pnp-Übergangs von -2 mV/K beträgt die Temperaturdifferenz für das Ab- bzw. Einschalten, beispielsweise des Leistungsverstärkers LV, 25 K. Die Schalthysterese läßt sich über den Strom durch das Gegenkopplungsnetzwerk R13 bis R16 und die Wahl des Widerstandes R13 einstellen.

**Patentansprüche**

1. Schaltungsanordnung mit einer eine temperaturunabhängige Referenzspannung ($U_{BG}$) liefernden Bandgap-Schaltung (BG), einer die Referenzspannung ($U_{BG}$) verstärkenden Verstärkerschaltung (V) und einer Sensorschaltung (TS), die die von der Verstärkerschaltung (V) verstärkte Referenzspannung ($U_R$) mit einer temperaturabhängigen Spannung ($U_T$) vergleicht und bei Erfüllung eines Vergleichskriteriums Mittel (T2) zum Steuern von mit der Sensorschaltung (TS) thermisch gekoppelten temperaturbestimmenden Schaltungsteilen (LV) aktiviert, wobei eine Rückwirkung der Sensor-Schaltung (TS) auf deren Eingang besteht, gekennzeichnet durch ein Gegenkopplungsnetzwerk (GK) der Verstärkerschaltung (V) und eine mitkoppelnde Rückkopplung der Sensorschaltung (TS) auf das Gegenkopplungsnetzwerk (GK) der Verstärkerschaltung.

2. Schaltungsanordnung nach Anspruch 1, dadurch gekennzeichnet, daß das Gegenkopplungsnetzwerk (GK) einen ohmschen Spannungsteiler (R1 bis R3; R13 bis R16) enthält und die verstärkte Referenzspannung ($U_R$) die Eingangsspannung der Sensorschaltung (TS) ist.

3. Schaltungsanordnung nach Anspruch 1 oder 2, dadurch gekennzeichnet, daß die Sensorschaltung (TS) folgende Komponenten aufweist:
einen von einer weitgehend temperaturunabhängigen Spannung ($U_{BG}$) vorgespannten, mit temperaturbestimmenden Schaltungsteilen (LV) thermisch gekoppelten pn-Halbleiterübergang, mindestens zwei von diesem pn-Halbleiterübergang gesteuerte Transistoren (T1, T2; T19 bis T21) sowie Vor- und Entladewiderstände (R4 bis R7; R17 bis R19).

4. Schaltungsanordnung nach Anspruch 3, dadurch gekennzeichnet, daß ein von dem pn-Halbleiterübergang gesteuerter Transistor (T1, T20) mit seinem Ausgangskreis auf das Gegenkopplungsnetzwerk (GK) rückgekoppelt ist und mindestens ein zweiter von dem pn-Halbleiterübergang gesteuerter Transistor (T2; T21) mit seinem Ausgangskreis mindestens einen Ab-/Einschaltsteuerkreis eines mit dem pn-Halbleiterübergang thermisch gekoppelten temperaturbestimmenden Schaltungsteils (LV) steuert.

5. Schaltungsanordnung nach Anspruch 4, dadurch gekennzeichnet, daß der Ausgangskreis des auf das Gegenkopplungsnetzwerk (GK) rückgekoppelten Transistors (T1; T20) einem ohmschen Widerstand (R3; R16) des Gegenkopplungsnetzwerks (GK) parallel geschaltet ist.

6. Schaltungsanordnung nach einem der Ansprüche 3 bis 5, dadurch gekennzeichnet, daß der pn-Halbleiterübergang eine in Flußrichtung vorgespannte Basis-Emitter-Strecke eines Transistors (T1; T19) ist.

7. Schaltungsanordnung nach einem der Ansprüche 4 bis 6, dadurch gekennzeichnet, daß der pn-Halbleiterübergang die Basis-Emitter-Strecke des mit seinem Ausgangskreis auf das Gegenkopplungsnetzwerk (GK) rückgekoppelten Transistors (T1) ist.

8. Schaltungsanordnung nach einem der Ansprüche 3 bis 5, dadurch gekennzeichnet, daß der pn-Halbleiterübergang eine in Flußrichtung vorgespannte Halbleiterdiode ist.

9. Schaltungsanordnung nach einem der Ansprüche 3 bis 8, dadurch gekennzeichnet, daß die von dem pn-Halbleiterübergang gesteuerten Transistoren (T1, T2; T20, T21) jeweils Basisvorwiderstände (R6, R7; R17, R18) besitzen.

10. Schaltungsanordnung nach Anspruch 9, dadurch gekennzeichnet, daß die Basisvorwiderstände (R6, R7; R17, R18) der von dem pn-Halbleiterübergang gesteuerten Transistoren (T1, T2; T20, T21) gleich groß sind.

11. Schaltungsanordnung nach einem der Ansprüche 9 und 10, dadurch gekennzeichnet, daß die Basis-Emitter-Strecken der von dem pn-Halbleiterübergang gesteuerten Transistoren (T1, T2; T20, T21) und ihre Basisvorwiderstände (R6, R7; R17, R18) jeweils parallel geschaltet sind.

12. Schaltungsanordnung nach einem der Ansprüche 9 bis 11, dadurch gekennzeichnet, daß parallel zu den Basis-Emitter-Strecken der vom pn-Halbleiterübergang gesteuerten Transistoren (T1, T2; T20, T21) und ihren Basisvorwiderständen (R6, R7; R17, R18) ein Parallelwiderstand (R5; R19) geschaltet ist.

13. Schaltungsanordnung nach Anspruch 12, dadurch gekennzeichnet, daß in Reihe zum Parallelwiderstand (R5) ein ohmscher Widerstand (R4) geschaltet ist, der mit dem Parallelwiderstand (R5) einen ohmschen Spannungsteiler bildet.

14. Schaltungsanordnung nach Anspruch 12, dadurch gekennzeichnet, daß in Reihe zum Parallelwiderstand (R5; R19) eine den pn-Halbleiterübergang bildende Halbleiterdiode geschaltet ist.

15. Schaltungsanordnung nach Anspruch 12, dadurch gekennzeichnet, daß in Reihe zum Parallelwiderstand (R19) der Ausgangskreis eines Transistors (T19) liegt, zwischen dessen Basis-Emitter-Strecke mindestens ein Widerstand (R13) des Gegenkopplungsnetzwerks (R13 bis R16) geschaltet ist.

16. Schaltungsanordnung nach einem der Ansprüche 1 bis 15, dadurch gekennzeichnet, daß die Verstärkerschaltung (V) bei einem hohen Leerlaufverstärkungsfaktor stark gegengekoppelt ist.

17. Schaltungsanordnung nach einem der Ansprüche 1 bis 16, dadurch gekennzeichnet, daß die Verstärkerschaltung (V) eine Bandbreitenbegrenzung (C1) enthält.

## Claims

1. Circuit arrangement comprising a band-gap circuit (BG) delivering a temperature-independent reference voltage ($U_{BG}$), an amplifier circuit (V) amplifying the reference voltage ($U_{BG}$), and a sensor circuit (TS), which compares the reference voltage ($U_R$) amplified by the amplifier circuit (V) with a temperature-dependent voltage ($U_T$), and, given satisfaction of a comparative criterion, activates means (TZ) for controlling temperature-determining circuit elements (LV) thermally coupled with the sensor circuit (TS), there being positive feedback of the sensor circuit (TS) onto its input, characterized by a negative feedback network (GK) of the amplifier circuit (V), and positive feedback of the sensor circuit (TS) onto the negative feedback network (GK) of the amplifier circuit.

2. Circuit arrangement according to Claim 1, characterized in that the negative feedback network (GK) contains a resistor-type voltage divider (R1 to R3; R13 to R16) and the amplified reference voltage ($U_R$) is the input voltage of the sensor circuit (TS).

3. Circuit arrangement according to Claim 1 or 2, characterized in that the sensor circuit (TS) has the following components: a p–n semiconductor junction, which is biased by a largely temperature-independent voltage ($U_{BG}$), and is thermally coupled with temperature-determining circuit elements (LV), at least two transistors (T1, T2; T19 to T21) controlled by this p–n semiconductor junction, and also recharge and discharge resistors (R4 to R7; R17 to R19).

4. Circuit arrangement according to Claim 3, characterized in that a transistor (T1, T20) controlled by the p–n semiconductor junction is coupled back with its output circuit on to the negative feedback network (GK), and at least one second transistor (T2; T21) controlled by the p–n semiconductor junction controls with its output circuit at least one stop/start control circuit of a temperature-determining circuit element (LV) thermally coupled with the p–n semiconductor junction.

5. Circuit arrangement according to Claim 4, characterized in that the output circuit of the transistor (T1; T20) coupled back onto the negative feedback network (GK) is connected to an ohmic resistance (R3; R16) of the negative feedback network (GK).

6. Circuit arrangement according to one of Claims 3 to 5, characterized in that the p–n semiconductor junction is a base-emitter section, biased in the forward direction, of a transistor (T1; T19).

7. Circuit arrangement according to one of Claims 4 to 6, characterized in that the p–n semiconductor junction is the base-emitter section of the transistor (T1) coupled back with its output circuit on to the negative feedback network (GK).

8. Circuit arrangement according to one of Claims 3 to 5, characterized in that the p–n semiconductor junction is a semiconductor diode biased in the forward direction.

9. Circuit arrangement according to one of Claims 3 to 8, characterized in that the transistors (T1, T2; T20, T21) controlled by the p–n semiconductor junction possess base series resistors (R6, R7; R17, R18) in each case.

10. Circuit arrangement according to Claim 9, characterized in that the base series resistors (R6, R7; R17, R18) of the transistors (T1, T2; T20, T21) controlled by the p–n semiconductor junction are of the same size.

11. Circuit arrangement according to one of Claims 9 and 10, characterized in that the base-emitter section of the transistors (T1, T2; T20, T21) controlled by the p–n semiconductor junction, and their base series resistors (R6, R7; R17, R18) are connected in parallel in each case.

12. Circuit arrangement according to one of Claims 9 to 11, characterized in that a shunt resistor (R5; R19) is connected in parallel to the base-emitter sections of the transistors (T1, T2; T20, T21) controlled by the p–n semiconductor junction, and to their base series resistors (R6, R7; R17, R18).

13. Circuit arrangement according to Claim 12, characterized in that there is connected in series to the shunt resistor (R5) an ohmic resistance (R4) which forms a resistor-type voltage divider with the shunt resistor (R5).

14. Circuit arrangement according to Claim 12, characterized in that there is connected in series to the shunt resistor (R5; R19) a semiconductor diode forming the p–n semiconductor junction.

15. Circuit arrangement according to Claim 12, characterized in that located in series with the shunt resistor (R19) is the output circuit of a transistor (T19) between the base-emitter section of which there is connected at least one resistor (R13) of the negative feedback network (R13 to R16).

16. Circuit arrangement according to one of Claims 1 to 15, characterized in that given a high open-loop gain the amplifier circuit (V) experiences strong negative feedback.

17. Circuit arrangement according to one of Claims 1 to 16, characterized in that the amplifier circuit (V) contains a bandwidth limitation (C1).

## Revendications

1. Montage comportant un circuit Bandgap (à la bande interdite) (BG) délivrant une tension de référence (U$_{BG}$) indépendante de la température, un circuit amplificateur (V) amplifiant la tension de référence (U$_{BG}$) et un circuit de détection (TS), qui compare la tension de référence (U$_R$), amplifiée par le circuit amplificateur (V) à une tension (U$_T$) dépendant de la température et, dans le cas où un critère de comparaison est satisfait, active des moyens (T2) servant à commander des parties de circuit (LV) qui sont accouplées thermiquement au circuit de détection (TS) et déterminent la température, avec une réaction du circuit de détection (TS) sur l'entrée de ce circuit, caractérisé par un réseau de contre-réaction (GK) du circuit amplificateur (V) et une réaction positive du circuit de détection (TS) sur le réseau de contre-réaction (GK) du circuit amplificateur.

2. Montage suivant la revendication 1, caractérisé par le fait que le réseau de contre-réaction (GK) contient un diviseur ohmique de tension (R1 à R3; R13 à R16) et que la tension de référence amplifiée (U$_R$) est la tension d'entrée du circuit de détection (TS).

3. Montage suivant la revendication 1 ou 2, caractérisé par le fait que le circuit de détection (TS) possède les composants suivants: une jonction semiconductrice pn polarisée par une tension (U$_{BG}$), dans une large mesure indépendante de la température, et couplée thermiquement à des parties de circuit (LV) déterminant la température, au moins deux transistors (T1, T2; T19 à T21) commandés par cette jonction semiconductrice pn, ainsi que des résistances de précharge et de décharge (R4 à R7; R17 à R19).

4. Montage suivant la revendication 3, caractérisé par le fait que le circuit de sortie d'un transistor (T1, T20), commandé par la jonction semiconductrice pn, est couplé par réaction au réseau de contre-réaction (GK) et que le circuit de sortie d'au moins un second transistor (T2; T21), commandé par la jonction semiconductrice pn, commande au moins un circuit de commande de débranchement/branchement d'une partie de circuit (LV) déterminant la température et couplée thermiquement à la jonction semiconductrice pn.

5. Montage suivant la revendication 4, caractérisé par le fait que le circuit de sortie du transistor (T1; T20) couplé par réaction au réseau de contre-réaction (GK), est branché en parallèle avec une résistance ohmique (R3; R16) du réseau de contre-réaction (GK).

6. Montage suivant l'une des revendications 3 à 5, caractérisé par le fait que la jonction semiconductrice pn est une voie base-émetteur, polarisée dans le sens direct, d'un transistor (T1; T19).

7. Montage suivant l'une des revendications 4 à 6, caractérisé par le fait que la jonction semiconductrice pn est la section base-émetteur du transistor (T1), dont le circuit de sortie est couplé par réaction au réseau de contre-réaction (GK).

8. Montage suivant l'une des revendications 3 à 5, caractérisé par le fait que la jonction semiconductrice pn est une diode semiconductrice polarisée dans le sens direct.

9. Montage suivant l'une des revendications 3 à 8, caractérisé par le fait que les transistors (T1, T2; T20, T21), commandés par la jonction semiconductrice pn, possèdent des résistances additionnelles de base respectives (R6, R7; R17, R18).

10. Montage suivant la revendication 9, caractérisé par le fait que les résistances additionnelles de base (R6, R7, R17, R18) des transistors (T1, T2; T20, T21), commandés par la jonction semiconductrice pn, possèdent la même valeur.

11. Montage suivant l'une des revendications 9 et 10, caractérisé par le fait que les sections base-émetteur des transistors (T1, T2; T20, T21), commandés par la jonction semiconductrice pn, et leurs résistances additionnelles de base (R6, R7; R17, R18) sont branchées respectivement en parallèle.

12. Montage suivant l'une des revendications 9 à 11, caractérisé par le fait qu'une résistance parallèle (R5; R19) est branchée en parallèle avec les sections base-émetteur des transistors (T1, T2; T20, T21), commandés par la jonction semiconductrice pn, et avec les résistances additionnelles de base (R6, R7; R17, R18) de ces transistors.

13. Montage suivant la revendication 12, caractérisé par le fait qu'en série avec la résistance en parallèle (R5) est branchée une résistance ohmique (R4) qui constitue, avec la résistance en parallèle (R5), un diviseur de tension ohmique.

14. Montage suivant la revendication 12, caractérisé par le fait qu'une diode semiconductrice constituant la jonction semiconductrice pn est branchée en série avec la résistance en parallèle (R5, R19).

15. Montage suivant la revendication 12, caractérisé par le fait qu'en série avec la résistance en parallèle (R19) se trouve disposé le circuit de sortie d'un transistor (T19), dans la section base-émetteur duquel est branchée au moins une résistance (R13) du circuit de contre-réaction (R13 à R16).

16. Montage suivant l'une des revendications 1 à 15, caractérisé par le fait que le circuit amplificateur (V) est couplé selon une contre-réaction forte, dans le cas d'un facteur élevé d'amplification à vide.

17. Montage suivant l'une des revendications 1 à 16, caractérisé par le fait que le circuit amplificateur (V) contient un dispositif (C1) de limitation de la largeur de bande.

# FIG 1

# FIG 2

EP 0 176 708 B1

# FIG 3